(19) Europäisches Patentamt
European Patent Office
Office européen des brevets

(11) **EP 1 625 660 B1**

(12) **EUROPÄISCHE PATENTSCHRIFT**

(45) Veröffentlichungstag und Bekanntmachung des Hinweises auf die Patenterteilung:
**13.12.2006 Patentblatt 2006/50**

(21) Anmeldenummer: **04733520.3**

(22) Anmeldetag: **18.05.2004**

(51) Int Cl.:
**H03K 17/16** $^{(2006.01)}$

(86) Internationale Anmeldenummer:
**PCT/CH2004/000301**

(87) Internationale Veröffentlichungsnummer:
**WO 2004/102806 (25.11.2004 Gazette 2004/48)**

(54) **HALBLEITERSCHALTERANORDNUNG**

SEMICONDUCTOR SWITCH ARRANGEMENT

MONTAGE DE COMMUTATEUR A SEMI-CONDUCTEUR

(84) Benannte Vertragsstaaten:
**DE FR GB**

(30) Priorität: **19.05.2003 EP 03405343**

(43) Veröffentlichungstag der Anmeldung:
**15.02.2006 Patentblatt 2006/07**

(73) Patentinhaber: **ABB Technology AG**
**8050 Zürich (CH)**

(72) Erfinder:
• **SCHLAPBACH Ulrich**
**CH-3097 Liebefeld (CH)**

• **SCHNELL, Raffael**
**CH-5703 Seon (CH)**

(74) Vertreter: **ABB Patent Attorneys**
**c/o ABB Schweiz AG,**
**Intellectual Property (CH-LC/IP),**
**Brown Boveri Strasse 6**
**5400 Baden (CH)**

(56) Entgegenhaltungen:
**DE-A- 10 152 879     US-A- 5 166 541**

**Beschreibung**

**Technisches Gebiet**

Die vorliegende Erfindung bezieht sich auf das Gebiet der Leistungselektronik. Sie betrifft eine elektronische Schaltung und ein Leistungshalbleitermodul nach dem Oberbegriff von Patentanspruch 1 bzw.6.

**Stand der Technik**

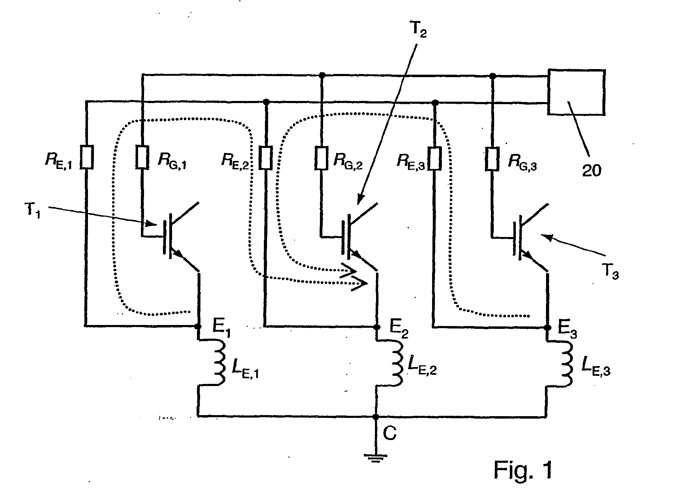

In gängigen Leistungshalbleitermodulen sind häufig zwei oder mehrere, im Allgemeinen identische, Leistungshalbleiterschalter parallel geschaltet, um eine gewünschte Gesamtstromkapazität zu erreichen, Eines solche Schaltung ist aus US 5 166 541 A bekannt. Dabei muss gewährleistet sein, dass ein durch das Leistungshalbleitermodul fliessender Gesamtstrom zu jedem Zeitpunkt möglichst gleichmässig auf die einzelnen Leistungshalb- leiterschalter verteilt wird, um zu verhindern, dass eine Stromkapazität eines einzelnen Leistungshalbleiterschalters überschritten wird. Kritisch sind in diesem Zusammenhang insbesondere Schaltvorgänge, da während dieser eine Rückwirkung von Ausgangsseiten auf Ansteuerseiten der Leistungshalbleiterschalter zu einer ungleichmässigen dynamischen Stromaufteilung führen kann. Dies wird im Folgenden anhand von Fig. 1 erläutert. Fig. 1 zeigt ein Schaltbild eines Leistungshalbleitermoduls mit drei parallel geschalteten Leistungshalbleiterschaltern nach dem Stand der Technik, welches sich zum Beispiel bei einem asymmetrischen Layout dreier bipolarer Transistoren $T_1$, $T_2$ und $T_3$ mit isoliertem Gate (IGBT) ergibt. Parasitäre emitterseitige Induktivitäten $L_{E,1}$, $L_{E,2}$, und $L_{E,3}$ haben dabei aufgrund unterschiedlicher Geometrien entsprechender elektrisch leitender Verbindungen zwischen jeweiligem Emitteranschluss $E_1$, $E_2$ bzw. $E_3$ und einem Knoten C unterschiedliche Werte. Bei einem Schaltvorgang werden aufgrund der unterschiedlichen Werte der Induktivitäten $L_{E,1}$, $L_{E,2}$, und $L_{E,3}$ unterschiedliche Spannungen über diesen induziert. Im vorliegenden Fall mit $L_{E,1} = L_{E,3} > L_{E2}$ resultiert daraus ein dynamischer Kreisstrom, d.h. ein Stromfluss von Emitteranschluss $E_1$ bzw. $E_3$ zu Emitteranschluss $E_2$, wie in der Fig. 1 durch gestrichelte Pfeile dargestellt ist. Dieser Stromfluss erzeugt wiederum unterschiedliche Spannungsabfälle $U_{R,1}$, $U_{R,2}$ und $U_{R,3}$ über Emitterwiderständen $R_{E,1}$, $R_{E,2}$ und $R_{E,3}$ und somit unterschiedliche Gatespannungen $U_{G,1}$, $U_{G,2}$ und $U_{G,3}$ an den IGBTs $T_1$, $T_2$ und $T_3$. Die unterschiedlichen Gatespannungen $U_{G,1}$, $U_{G,2}$ und $U_{G,3}$ bewirken schliesslich Schwingungen, Kreisströme und die erwähnte ungleichmässige dynamische Stromaufteilung , was zu einer Reduktion einer Schaltleistung gegenüber einem theoretisch möglichen Wert führt (engl. "derating").

Verschiedene Methoden sind bekannt, mit denen dieser ungleichmässigen dynamischen Stromaufteilung entgegengewirkt werden kann.

Zunächst kommt eine getrennte Ansteuerung in Verbindung mit einer ausgangsseitigen Entkopplung mittels zusätzlicher induktiver oder resistiver Bauelemente, durch welche die unterschiedlichen Werte der Induktivitäten $L_{E,1}$, $L_{E,2}$, und $L_{E,3}$ ausgeglichen werden, in Frage. Eine solche Lösung führt jedoch zu einem erhöhten Platzbedarf, bei grossen Strömen aufgrund von Anforderungen an die Bauelemente auch zu erhöhten Kosten.

Denkbar ist auch jeweils eine harte, direkte Verbindung sowohl der Ausgangsseiten als auch der Ansteuerseiten, wobei die Ansteuerseiten vorzugsweise mittels Entkopplungswiderständen entkoppelt werden. Falls eine stationäre wie dynamische Symmetrie erreicht werden kann, ist dies eine brauchbare und kostengünstige Lösung. Da dies jedoch im Allgemeinen insbesondere eine geometrische Symmetrie der Leistungshalbleitermodule oder zumindest eine untereinander identische oder spiegelverkehrte Ausführung von Ansteuer- und Leistungszuleitungen erforderlich macht, ist ein derartiges Vorgehen bei Leistungshalbleitermodulen mit mehr als zwei Leistungshalbleiterschaltern im allgemeinen nicht oder höchstens unter grossem Aufwand anwendbar. Auch ist die beschriebene Lösung im Allgemeinen nicht anwendbar, wenn Leistungshalbleiterschalter, die sich in getrennten Submodulen befinden, oder gar komplette Leistungshalbleitermodule, parallel geschaltet werden sollen.

Eine weitere Variante verwendet ebenfalls die harte, direkte Verbindung der Ausgangsseiten, entkoppelt jedoch die Ansteuerseiten durch eine Verwendung getrennter Ansteuereinheiten. Dies stellt jedoch im Hinblick auf Synchronizität und Affinität der Ansteuereinheiten hohe Anforderungen, was wiederum zu erhöhten Herstellungskosten führt.

**Darstellung der Erfindung**

Es ist somit Aufgabe der Erfindung, eine elektronische Schaltung mit mindestens zwei parallel geschalteten Leistungshalbleiterschaltern anzugeben, bei welcher eine möglichst gleichmässige dynamische Stromaufteilung auf die mindestens zwei Leistungshalbleiterschalter erreicht wird.

Diese und weitere Aufgaben werden durch eine elektronische Schaltung der eingangs genannten Art mit den Merkmalen des unabhängigen Patentanspruchs gelöst. Weitere vorteilhafte Ausgestaltungen der Erfindung sind in den abhängigen Ansprüchen angegeben.

Bei der erfindungsgemässen elektronischen Schaltung, insbesondere zur Verwendung als Leistungsschalter, ist eine Ansteuereinheit, welche mindestens ein Ansteuersignal erzeugt, und zwei oder mehrere durch das Ansteuersignal synchron schaltbare Leistungshalbleiterschalter mit je einem ersten und einem zweiten Hauptanschluss, wobei die ersten und die zweiten Hauptanschlüsse der Leistungshalbleiterschalter jeweils untereinander elektrisch parallel geschaltet sind, vorgesehen. Für jeden der Leistungshalbleiterschalter ist eine erste und eine zweite elektrisch leitende Verbindung zum Anschluss an die Ansteuereinheit vorgesehen, wobei in jeder der ersten elektrisch leitenden Verbindungen eine erste Induktivität und in jeder der zweiten elektrisch leitenden Verbindungen eine zweite Induktivität vorgesehen ist und für jeden der Leistungshaibteiterschalter die erste Induktivität mit der zweiten Induktivität gekoppelt ist. Erfindungsgemäss ist in jedem Paar von ersten und zweiten elektrisch leitenden Verbindungen je eine Gleichtaktunterdrückungsdrossel vorgesehen, d.h. für jeden der Leistungshalbleiterschalter ist je eine Gleichtaktunterdrückungsdrossel vorgesehen. Dabei bildet jeweils eine erste Wicklung der Gleichtaktunterdrückungsdrossel die erste Induktivität und eine zweite Wicklung der Gleichtaktunterdrückungsdrossel die zweite Induktivität.

Durch die gekoppelten Induktivitäten werden Kopplungs- und Übersprechprobleme während Schaltvorgängen reduziert. Dynamische Kreisströme werden minimiert und Schwingungen zwischen den Leistungshalbleiterschaltern werden wirkungsvoll unterdrückt. Die erfindungsgemässe elektronische Schaltung weist sowohl die Vorzüge direkt parallelgeschalteter Ausgangsseiten als auch die Vorzüge einer separaten Ansteuerung der Leistungshalbleiterschalter auf, ohne dass eine Synchronisation mehrerer getrennter Steuereinheiten oder eine kostspielige Beschaltung im Ausgangskreis notwendig wäre, was eine kostengünstige Herstellung ermöglicht. Eine Symmetrisierung der Ausgangsseiten kann auf ein Gleichstromverhalten optimiert werden, insbesondere durch eine gleichmässige Aufteilung eines Gatewiderstands auf Gate und Emitter der Leistungshalbleiterschalter. Durch die Gleichtaktunterdrückungsdrosseln werden die Paare von ersten und zweiten elektrisch leitenden Verbindungen vom Leistungskreis entkoppelt, welcher durch die Leistungshalbleiterschalter zwischen Kathodenanschlüssen und einem gemeinsamen Knoten der Leistungshalbleiterschalter verläuft. Durch die Entkopplung wird weiterhin eine gleichmässige dynamische Stromaufteilung auf entsprechende Pfade im Leistungskreis gewährleistet.

Diese und weitere Aufgaben, Vorteile und Merkmale der Erfindung werden aus der nachfolgenden, detaillierten Beschreibung eines bevorzugten Ausführungsbeispiels der Erfindung in Verbindung mit der Zeichnung offensichtlich.

## Kurze Beschreibung der Zeichnung

Es zeigen:

Fig. 1 zeigt eine elektronische Schaltung mit drei parallel geschalteten Leistungshalbleiterschaltern nach dem Stand der Technik.

Fig. 2 zeigt eine erfindungsgemässe elektronische Schaltung.

Fig. 3a zeigt ein Schaltbild einer Messanordnung zur Messung einer Reihen-Induktivität einer Gleichtaktunterdrückungsdrossel $D_i$.

Fig. 3b zeigt ein Schaltbild einer Messanordnung zur Messung einer GleichtaktInduktivität einer Gleichtaktunterdrückungsdrossel $D_i$.

Fig. 4 zeigt eine bevorzugte Ausgestaltung einer erfindungsgemässen elektronischen Schaltung.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

## Wege zur Ausführung der Erfindung

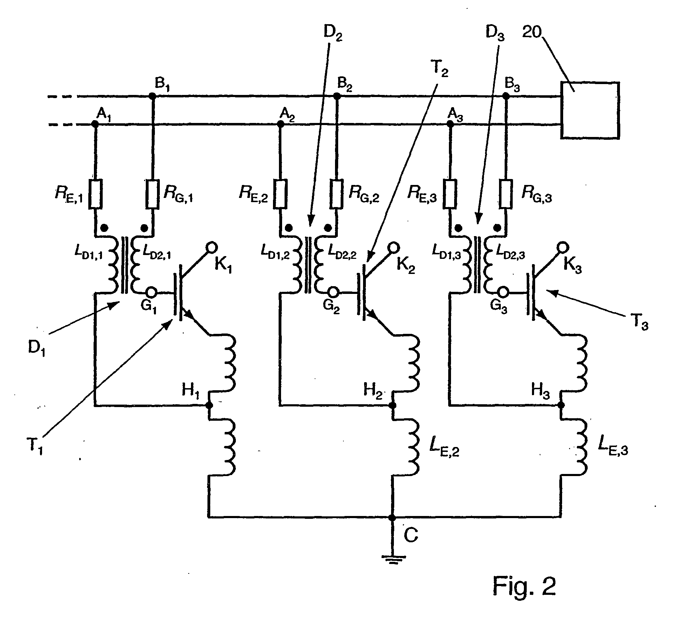

Fig. 2 zeigt eine erfindungsgemässe elektronische Schaltung mit drei parallel geschalteten IGBTs $T_i$, mit $i \in \{1,2,3\}$, als Leistungshalbleiterschalter. Diese sind mittels einer gemeinsamen Ansteuereinheit 20 synchron schaltbar. Zu diesem Zweck ist jedem der IGBTs $T_i$ über je ein Ansteuerzuleitungspaar ein von der gemeinsamen Ansteuereinheit 20 erzeugtes Ansteuersignal zuführbar. Es ist aber auch denkbar, dass die synchron schaltbaren Leistungshalbleiterschalter $T_i$ unipolare Feldeffekttransistoren mit isoliertem Gate (MOS-FET) sind. Jedes Ansteuerzuleitungspaar umfasst gemäss Fig. 2 eine erste Ansteuerzuleitung, welche zwischen Knoten $A_i$ und Hilfsemitteranschluss $H_i$ vorgesehen ist, und eine zweite Ansteuerzuleitung, welche zwischen Knoten $B_i$ und Gateanschluss $G_i$ vorgesehen ist. Erfindungsgemäss ist in jedem Paar von ersten und zweiten elektrisch leitenden Verbindungen (Ansteuerzuleitungspaare) je eine Gleichtaktunterdrückungsdrossel $D_i$ vorgesehen, d.h. für jeden der Leistungshalbleiterschalter $T_i$ ist je eine Gleichtaktunter-

drückungsdrossel $D_i$ vorgesehen. Dabei bildet gemäss Fig. 2 jeweils eine erste Wicklung der Gleichtaktunterdrückungs-drossel $D_i$ die erste Induktivität $L_{D1,i}$ und eine zweite Wicklung der Gleichtaktunterdrückungsdrossel $D_i$ die zweite In-duktivität $L_{D2,i}$. Durch die Gleichtaktunterdrückungsdrosseln $D_i$ werden die Ansteuerzuleitungspaare, d.h. die Paare von ersten und zweiten elektrisch leitenden Verbindungen, von einem Leistungskreis entkoppelt, welcher durch die IGBTs $T_i$ zwischen Kathodenanschlüssen $K_i$ und einem gemeinsamen Knoten C verläuft. Durch die Entkopplung wird eine gleichmässige dynamische Stromaufteilung auf Pfade $K_1$-C, $K_2$-C und $K_3$-C im Leistungskreis gewährleistet. Vorzugsweise wird dabei ein Gatewiderstand so aufgeteilt, dass für $i \in \{1,2,3\}$ $R_{G,i} \approx R_{E,i}$ gilt, wobei vorzugsweise für $R_{G,i}$ und $R_{E,i}$ ein Wert des halben Nenngatewiderstandes $R_{G,nom}$ des IGBTs, d.h. $R_{G,i} = R_{E,i} = 1/2\ R_{G,nom}$ gewählt wird.

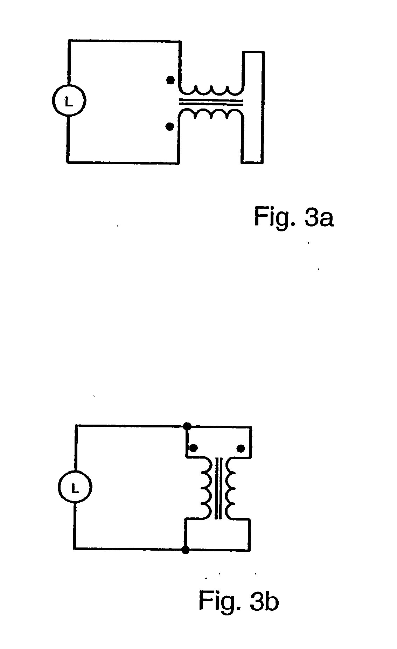

Reihen-Induktivitäten $L_{D,i}^{(G)}$ der Gleichtaktunterdrückungsdrosseln $D_i$ werden dabei vorzugsweise so klein wie möglich, vorzugsweise kleiner oder gleich 200nH gewählt. Die Reihen-Induktivität der Gleichtaktunterdrückungsdrossel $D_i$ ist dabei diejenige Induktivität, die gemessen wird, wenn beide Windungen der Gleichtaktunterdrückungsdrossel $D_i$ in Serie geschaltet sind. Fig. 3a zeigt ein Schaltbild einer Messanordnung zur Messung der Reihen-Induktivität der Gleichtaktunterdrückungsdrossel $D_i$.

Gleichtakt-Induktivitäten $L_D^{(G)}$ der Gleichtaktunterdrückungsdrosseln $D_i$ werden dabei vorzugsweise zumin-dest annähernd wie folgt gewählt: Ausgehend von einem Maximum $\Delta L_E$ der Differenzen $L_{E,i} - L_{E,j}$ zwischen zwei Emit-terinduktivitäten mit $i \neq j \in \{1,2,3\}$ und einer vorgegebenen, maximal zulässigen Differenz $\Delta U_{GE}$ zwischen zwei Gate-Emitterspannugen $U_{GE,i}$ und $U_{GE,j}$, welche zwischen Hilfsemitteranschlüssen $H_i$ bzw. $H_j$ und Gateanschlüssen $G_i$ bzw. $G_j$ zweier IGBTs $T_i$ bzw. $T_j$ mit $i \neq j \in \{1,2,3\}$ anliegen, lässt sich eine minimale Gleichtakt-Induktivität $L_D^{(G)}$ berechnen. Da die IGBTs $T_i$ spannungsgesteuerte Bauelemente sind, bei welchen ein Kollektorstrom über die Gate-Emitterspannug $U_{GE,i}$ eingestellt werden kann, muss die maximal zulässige Spannungsdifferenz $\Delta U_{GE}$ über einen maximal zulässigen Kollektorstromunterschied in einem interessierenden Bereich aus einer Transfercharakteristik der IGBTs $T_i$ ausgelesen werden.

Eine zulässige Differenz einer Gateladung $\Delta Q_{GE}$ ergibt sich durch Multiplikation der maximal zulässige Span-nungsdifferenz $\Delta U_{GE}$ mit einer Gate-Emitterkapazität $C_{GE}$ gemäss

$$\Delta Q_{GE} = \Delta U_{GE} \cdot C_{GE}\ ,$$

wobei angenommen wurde, dass die Gate-Emitterkapazität $C_{GE,i}$ für alle drei IGBTs $T_i$ den gleichen Wert $C_{GE}$ aufweist.

Ein maximal zulässiger Unterschied $\Delta I_G$ zwischen Gateströmen $I_i$ und $I_j$ mit $i \neq j \in \{1,2,3\}$ kann dann errechnet werden, indem die maximal zulässige Differenz der Gateladung $\Delta Q_{GE}$ durch eine relevante Zeit $t_R$, während welcher sich die Spannung über den unterschiedlichen Emitterinduktivitäten aufbaut, geteilt wird, das heisst

$$\Delta I_G = \frac{\Delta Q_{GE}}{t_R}$$

Für die minimale Gleichtakt-Induktivität $L_D^{(G)}$ ergibt sich somit, wenn eine Spannungszeitfläche über der Differenz der Emitterinduktivitäten durch den zulässigen Gatestromunterschied geteilt wird:

$$L_D^{(G)} = \frac{U}{\Delta I_G / \Delta t} = \frac{U \cdot \Delta t}{\Delta I_G}$$

Die Spannungszeitfläche über dem Maximum $\Delta L_E$ der Differenzen der Emitterinduktivitäten $L_{E,i} - L_{E,j}$ kann durch Multiplikation von $\Delta L_E$ mit einem grösst möglichen Strom, dem Kurzschlussstrom $I_{SC}$ der IGBTs, errechnet werden:

$$U \cdot \Delta t = \Delta L_E \cdot I_{SC} .$$

Somit ergibt sich

$$L_D^{(G)} = \frac{U}{\Delta I_G / \Delta t} = \frac{\Delta L_E \cdot I_{SC}}{\Delta I_G} .$$

Die Gleichtakt-Induktivität der Gleichtaktunterdrückungsdrosseln $D_i$ ist dabei diejenige Induktivität, die gemessen wird, wenn beide Windungen der Gleichtaktunterdrückungsdrossel $D_i$ parallel geschaltet sind. Fig. 3b zeigt ein Schaltbild einer Messanordnung zur Messung der Gleichtakt-Induktivität der Gleichtaktunterdrückungsdrossel $D_i$.

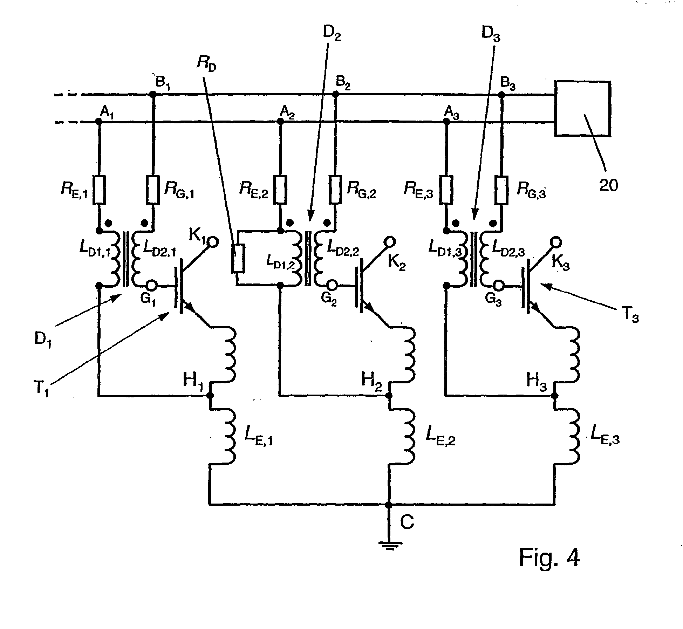

Fig. 4 zeigt eine bevorzugte Ausgestaltung der erfindungsgemässen elektronischen Schaltung. Dabei ist zwischen den Knoten $A_2$ und den Hilfsemitteranschlüssen $H_2$ parallel zu der Gleichtaktunterdrückungsdrossel $D_2$ ein Widerstand $R_D$ vorgesehen, um Spitzenwerte $\hat{U}_D$ zwischen der Ansteuereinheit 20 und dem Leistungskreis zu minimieren. Vorzugsweise wird für $R_D$ ein Wert von einigen Ohm bis zu einigen zehn Ohm gewählt.

Ein erfindungsgemässes Leistungshalbleitermodul umfasst ein Modulgehäuse an sich bekannter Art und eine erfindungsgemässe elektronische Schaltung, wie sie in diesem Abschnitt beschrieben wurde. Vorzugsweise sind dabei sowohl die Leistungshalbleiterschalter wie auch die Ansteuereinheit 20 und/oder die ersten und zweiten Induktivitäten im Modulgehäuse untergebracht. Vorteilhaft kann jedoch die Ansteuereinheit 20 und/oder die ersten und zweiten Induktivitäten auch ausserhalb des Modulgehäuses vorgesehen, insbesondere angeschraubt oder angesteckt, sein.

In einer bevorzugten Weiterbildung des erfindungsgemässen Leistungshalbleitermoduls umfasst dieses zwei oder mehrere Submodule, und die mindestens zwei von der Steuereinheit angesteuerten Leistungshalbleiterschalter befinden sich nicht alle im selben Submodul. In diesem Fall kann die Erfindung besonders vorteilhaft eingesetzt werden, da eine untereinander identische oder spiegelverkehrte Ausführung von Ansteuer- und Leistungszuleitungen bei Leistungshalbleiterschaltern, welche sich in verschiedenen Submodulen befinden, im Allgemeinen nicht realisierbar ist und somit bekannte, im Stand der Technik beschriebene Behelfslösungen nicht zur Verfügung stehen.

**Bezugszeichenliste**

| | |
|---|---|
| 20 | Ansteuereinheit |
| $A_1$, $A_2$, $A_3$ | Knoten |
| $B_1$, $B_2$, $B_3$ | Knoten |
| $D_1$, $D_2$, $D_3$ | Gleichtaktunterdrückungsdrossel |
| $E_1$, $E_2$, $E_3$ | Emitteranschluss |
| $G_1$, $G_2$, $G_3$ | Gateanschluss |
| $H_1$, $H_2$, $H_3$ | Hilfsemitteranschluss |
| $K_1$, $K_2$, $K_3$ | Kathodenanschluss |
| $L_{D1,1}$, $L_{D1,2}$, $L_{D1,3}$ | Erste Induktivität |
| $L_{D2,1}$, $L_{D2,2}$, $L_{D2,3}$ | Zweite Induktivität |
| $R_D$ | Begrenzungswiderstand |
| $T_1$, $T_2$, $T_3$ | IGBT, Leistungshalbleiterschalter |

**Patentansprüche**

1. Elektronische Schaltung, insbesondere zur Verwendung als Leistungsschalter, umfassend

   - eine Ansteuereinheit (20), welche mindestens ein Ansteuersignal erzeugt,
   - zwei oder mehrere durch das Ansteuersignal synchron schaltbare Leistungshalbleiterschalter ($T_1$, $T_2$, $T_3$) mit je einem ersten und einem zweiten Hauptanschluss, wobei die ersten und die zweiten Hauptanschlüsse der Leistungshalbleiterschalter ($T_1$, $T_2$, $T_3$) jeweils untereinander elektrisch parallel geschaltet sind,
   - für jeden der Leistungshalbleiterschalter ($T_1$, $T_2$, $T_3$) eine erste und eine zweite elektrisch leitende Verbindung zum Anschluss an die Ansteuereinheit (20),
- in jeder der ersten elektrisch leitenden Verbindungen eine erste Induktivität ($L_{D1,1}$, $L_{D1,2}$, $L_{D1,3}$),
- in jeder der zweiten elektrisch leitenden Verbindungen eine zweite Induktivität ($L_{D2,1}$, $L_{D2,2}$, $L_{D2,3}$), wobei für jeden der Leistungshalbleiterschalter ($T_1$, $T_2$, $T_3$) die erste Induktivität ($L_{D1,1}$, $L_{D1,2}$, $L_{D1,3}$) mit der zweiten Induktivität ($L_{D2,1}$, $L_{D2,2}$, $L_{D2,3}$) gekoppelt ist

**dadurch gekennzeichnet, dass**

- für jeden der Leistungshalbleiterschalter ($T_1$, $T_2$, $T_3$) je eine Gleichtaktunterdrückungsdrossel ($D_1$, $D_2$, $D_3$) vorgesehen ist, wobei jeweils eine erste Wicklung der Gleichtaktunterdrückungsdrossel ($D_1$, $D_2$, $D_3$) die erste Induktivität ($L_{D1,1}$, $L_{D1,2}$, $L_{D1,3}$) bildet und eine zweite Wicklung der Gleichtaktunterdrückungsdrossel ($D_1$, $D_2$, $D_3$) die zweite Induktivität ($L_{D2,1}$, $L_{D2,2}$, $L_{D2,3}$) bildet, und dass

- für jede Gleichtaktunterdrückungsdrossel ($D_1$, $D_2$, $D_3$) eine Gleichtakt-Induktivität $L_{D,i}^{(G)}$ gewählt wird, die grösser ist als eine minimale Gleichtakt-Induktivität $L_D^{(G)}$ mit

$$L_D^{(G)} = \frac{\Delta L_E \cdot I_{SC}}{\Delta I_G},$$

wobei
- $\Delta L_E$ ein maximale Differenz $L_{E,i}$ - $L_{E,j}$ zwischen zwei Emitterinduktivitäten $L_{E,i}$ und $L_{E,j}$ mit $i \neq j \in \{1,2,3\}$,
- $I_{SC}$ ein Kurzschlussstrom der Leistungshalbleiterschalter ($T_1$, $T_2$, $T_3$), und
- $\Delta I_G$ eine maximal zulässige Differenz $I_i$ - $I_j$ zwischen zwei Gateströmen $I_i$ und $I_j$, mit $i \neq j \in \{1,2,3\}$ ist.

2. Elektronische Schaltung nach Anspruch 1, **dadurch gekennzeichnet, dass**

- die synchron schaltbaren Leistungshalbleiterschalter ($T_1$, $T_2$, $T_3$) bipolare Transistoren mit isoliertem Gate (IGBT) sind.

3. Elektronische Schaltung nach Anspruch 1, **dadurch gekennzeichnet, dass**

- die synchron schaltbaren Leistungshalbleiterschalter ($T_1$, $T_2$, $T_3$) unipolare Feldeffekttransistoren mit isoliertem Gate (MOS-FET) sind.

4. Elektronische Schaltung nach Anspruch 2, **dadurch gekennzeichnet, dass**

- die erste elektrisch leitende Verbindung für jeden der IGBTs ($T_1$, $T_2$, $T_3$) einen Hilfsemitteranschluss ($H_1$, $H_2$, $H_3$) kontaktiert und
- parallel zu einer der ersten Induktivitäten ($L_{D1,1}$, $L_{D1,2}$, $L_{D1,3}$) ein Begrenzungswiderstand ($R_D$) vorgesehen ist.

5. Leistungshalbleitermodul, umfassend ein Modulgehäuse, **dadurch gekennzeichnet, dass**

- das Leistungshalbleitermodul eine elektronische Schaltung nach einem der Ansprüche 1 bis 4 umfasst.

6. Leistungshalbleitermodul nach Anspruch 5, **dadurch gekennzeichnet, dass**

- das Leistungshalbleitermodul mindestens zwei Submodule umfasst und
- die zwei oder mehreren durch das Ansteuersignal synchron schaltbaren Leistungshalbleiterschalter ($T_1$, $T_2$, $T_3$) sich nicht alle im selben Submodul befinden.

**Claims**

1. An electronic circuit, in particular for use as a power switch, comprising

- a drive unit (20), which generates at least one drive signal,
- two or more power semiconductor switches ($T_1$, $T_2$, $T_3$) each having a first and a second main terminal, which power semiconductor switches can be switched synchronously by the drive signal, the first and the second main terminals of the power semiconductor switches ($T_1$, $T_2$, $T_3$) in each case being electrically connected in parallel among one another,
- for each of the power semiconductor switches ($T_1$, $T_2$, $T_3$) a first and a second electrically conductive connection for connection to the drive unit (20),
- a first inductance ($L_{D1,1}$, $L_{D1,2}$, $L_{D1,3}$) in each of the first electrically conductive connections,
- a second inductance ($L_{D2,1}$, $L_{D2,2}$, $L_{D2,3}$) in each of the second electrically conductive connections, the first inductance ($L_{D1,1}$, $L_{D1,2}$, $L_{D1,3}$) being coupled to the second inductance ($L_{D2,1}$, $L_{D2,2}$, $L_{D2,3}$) for each of the power semiconductor switches ($T_1$, $T_2$, $T_3$),

**characterized in that**

- a respective common-mode rejection inductor ($D_1$, $D_2$, $D_3$) is provided for each of the power semiconductor switches ($T_1$, $T_2$, $T_3$), in each case a first winding of the common-mode rejection inductor ($D_1$, $D_2$, $D_3$) forming the first inductance ($L_{D1,1}$, $L_{D1,2}$, $L_{D1,3}$) and a second winding of the common-mode rejection inductor ($D_1$, $D_2$, $D_3$) forming the second inductance ($L_{D2,1}$, $L_{D2,2}$, $L_{D2,3}$), and **in that**

- for each common-mode rejection inductor ($D_1$, $D_2$, $D_3$) a common-mode inductance $L_{D,i}^{(G)}$ is chosen which is greater than a minimum common-mode inductance

$$L_D^{(G)} \text{ where } L_D^{(G)} = \frac{\Delta L_E \cdot I_{SC}}{\Delta I_G} \text{ , where}$$

- $\Delta L_E$ is a maximum difference $L_{E,i}-L_{E,j}$ between two emitter inductances $L_{E,i}$ and $L_{E,j}$ where $i \neq j \in \{1, 2, 3\}$,
- $I_{SC}$ is a short-circuit current of the power semiconductor switches ($T_1$, $T_2$, $T_3$) and
- $\Delta I_G$ is a maximum permissible difference $I_i-I_j$ between two gate currents $I_i$ and $I_j$, where $i \neq j \in \{1,2,3\}$.

2. The electronic circuit as claimed in claim 1,
   **characterized in that**

   - the synchronously switchable power semiconductor switches ($T_1$, $T_2$, $T_3$) are insulated gate bipolar transistors (IGBT).

3. The electronic circuit as claimed in claim 1,
   **characterized in that**

   - the synchronously switchable power semiconductor switches ($T_1$, $T_2$, $T_3$) are unipolar insulated gate field effect transistors (MOS-FET).

4. The electronic circuit as claimed in claim 2,
   **characterized in that**

   - the first electrically conductive connection for each of the IGBTs ($T_1$, $T_2$, $T_3$) makes contact with an auxiliary emitter terminal ($H_1$, $H_2$, $H_3$) and
   - a limiting resistor ($R_D$) is provided in parallel with one of the first inductances ($L_{D1,1}$, $L_{D1,2}$, $L_{D1,3}$).

5. A power semiconductor module, comprising a module housing, **characterized in that**

   - the power semiconductor module comprises an electronic circuit as claimed in one of claims 1 to 4.

6. The power semiconductor module as claimed in claim 5, **characterized in that**

   - the power semiconductor module comprises at least two submodules, and
   - the two or more power semiconductor switches ($T_1$, $T_2$, $T_3$) that can be switched synchronously by the drive signal are not all situated in the same submodule.

**Revendications**

1. Circuit électronique, notamment destiné à être utilisé comme commutateur de puissance, comprenant

   - une unité de commande (20) qui génère au moins un signal de commande,
   - deux commutateurs semiconducteurs de puissance ($T_1$, $T_2$, $T_3$) ou plus pouvant être commutés de manière synchrone par le signal de commande, comprenant chacun une première et une deuxième borne principale, les premières et deuxièmes bornes principales des commutateurs semiconducteurs de puissance ($T_1$, $T_2$, $T_3$) étant à chaque fois branchées électriquement en parallèle entre elles,
   - pour chacun des commutateurs semiconducteurs de puissance ($T_1$, $T_2$, $T_3$), une première et une deuxième liaison électriquement conductrice destinée à être raccordée à l'unité de commande (20),
   - une première inductance ($L_{D1,1}$, $L_{D1,2}$, $L_{D1,3}$) dans chacune des premières liaisons électriquement conductrices,
   - une deuxième inductance ($L_{D2,1}$, $L_{D2,2}$, $L_{D2,3}$) dans chacune des deuxièmes liaisons électriquement conductrices, la première inductance ($L_{D1,1}$, $L_{D1,2}$, $L_{D1,3}$) étant couplée avec la deuxième inductance ($L_{D2,1}$, $L_{D2,2}$, $L_{D2,3}$) pour chacun des commutateurs semiconducteurs de puissance ($T_1$, $T_2$, $T_3$),

   **caractérisé en ce que**

   - une bobine de suppression en mode commun ($D_1$, $D_2$, $D_3$) étant prévue pour chacun des commutateurs semiconducteurs de puissance ($T_1$, $T_2$, $T_3$), un premier enroulement de la bobine de suppression en mode commun ($D_1$, $D_2$, $D_3$) formant à chaque fois la première inductance ($L_{D1,1}$, $L_{D1,2}$, $L_{D1,3}$) et un deuxième enroulement de la bobine de suppression en mode commun ($D_1$, $D_2$, $D_3$) formant à chaque fois la deuxième inductance ($L_{D2,1}$, $L_{D2,2}$, $L_{D2,3}$) et que

   - une inductance en mode commun $L_{D,i}^G$ étant choisie pour chaque bobine de suppression en mode commun ($D_1$, $D_2$, $D_3$), laquelle est supérieure à une inductance en mode commun minimale $L_D^G$, avec

   $$L_D^G = \frac{\Delta L_E \bullet I_{sc}}{\Delta I_G} \text{ où}$$

   - $\Delta L_E$ désigne une différence maximale $L_{E,i}$ - $L_{E,j}$ entre deux inductances d'émetteur $L_{E,i}$ et $L_{E,j}$ avec $i \neq j \in \{1, 2, 3\}$,
   - $I_{sc}$ désigne un courant de court-circuit des commutateurs semiconducteurs de puissance ($T_1$, $T_2$, $T_3$) et
   - $\Delta I_G$ désigne une différence maximale admissible $I_i$ - $I_j$ entre deux courants de gâchette $I_i$ et $I_j$ $i \neq j \in \{1, 2, 3\}$.

2. Circuit électronique selon la revendication 1, **caractérisé en ce que** les commutateurs semiconducteurs de puissance ($T_1$, $T_2$, $T_3$) pouvant être commutés de manière synchrone sont des transistors bipolaires à gâchette isolée (IGBT).

3. Circuit électronique selon la revendication 1, **caractérisé en ce que** les commutateurs semiconducteurs de puissance ($T_1$, $T_2$, $T_3$) pouvant être commutés de manière synchrone sont des transistors à effet de champ unipolaires à gâchette isolée (MOS-FET).

4. Circuit électronique selon la revendication 2, **caractérisé en ce que** la première liaison électriquement conductrice pour chacun des IGBT ($T_1$, $T_2$, $T_3$) est en contact avec une borne d'émetteur auxiliaire ($H_1$, $H_2$, $H_3$) et une résistance de limitation ($R_D$) est prévue en parallèle avec l'une des premières inductances ($L_{D1,1}$, $L_{D1,2}$, $L_{D1,3}$).

5. Module semiconducteur de puissance comprenant un boîtier de module, **caractérisé en ce que** le module semiconducteur de puissance comprend un circuit électronique selon l'une des revendications 1 à 4.

6. Module semiconducteur de puissance selon la revendication 5, **caractérisé en ce que** le module semiconducteur de puissance comprend au moins deux sous-modules et les deux commutateurs semiconducteurs de puissance ($T_1$, $T_2$, $T_3$) ou plus pouvant être commutés de manière synchrone par le signal de commande ne se trouvent pas tous dans le même sous-module.

Fig. 1

Fig. 2

Fig. 3a

Fig. 3b

Fig. 4